# EUROPÄISCHE PATENTSCHRIFT

(11) **EP 0 468 424 B1**
(45) Veröffentlichungstag und Bekanntmachung des Hinweises auf die Patenterteilung: **12.07.1995**
(21) Anmeldenummer: 91112279.4
(22) Anmeldetag: 22.07.1991
(51) Int. Cl.: H03K 17/945

(54) **Elektronisches Schaltgerät mit Anwesenheitsindikator**
Electronic switching apparatus with presence indicator
Appareil de commutation électronique avec indicateur de présence

(30) Priorität: 24.07.1990 DE 4023502; 06.05.1991 DE 4114763
(43) Veröffentlichungstag der Anmeldung: 29.01.1992
(73) Patentinhaber: i f m electronic gmbh, D-45127 Essen (DE)
(72) Erfinder: Lamarche, Jean-Luc, Dipl.-Ing., W-7994 Langenargen (DE)
(74) Vertreter: Gesthuysen, Hans Dieter, Dipl.-Ing.

(56) Entgegenhaltungen:
- EP-A- 0 092 711
- EP-A- 0 244 743
- DE-A- 2 550 101
- GB-A- 2 078 039

## Beschreibung

Die Erfindung betrifft ein elektronisches Schaltgerät zum Anschluß an Gleichspannung als Versorgungsspannung, insbesondere induktiver, kapazitiver oder optoelektronischer Näherungsschalter oder Strömungswächter, mit einem von außen beeinflußbaren Anwesenheitsindikator, z. B. einem Oszillator, mit einem dem Anwesenheitsindikator nachgeordneten Schaltverstärker, mit einem von dem Anwesenheitsindikator über den Schaltverstärker steuerbaren elektronischen Schalter, z. B. einem Transistor, einem Thyristor oder einem Triac, mit einer vier Gleichrichterelemente aufweisenden Gleichrichterbrücke und mit zwei Versorgungsanschlüssen, wobei der Schaltverstärker zwei antivalente Steuerausgänge aufweist. Dabei kann es sich um ein Zweileiter-Schaltgerät, aber auch um ein Dreileiter-Schaltgerät - mit zwei Versorgungsanschlüssen und mit einem zusätzlichen Signalausgang - handeln. Ein ähnliches Schaltgerät, allerdings für Wechselspannungsanschluß und mit drei Versorgungsanschlüssen, ist aus DE-A-25 50 101 bekannt.

Elektronische Schaltgeräte der hier grundsätzlich in Rede stehenden Art sind kontaktlos ausgeführt und werden seit nunmehr etwa zwanzig Jahren in zunehmendem Maße anstelle von elektrischen, mechanisch betätigten Schaltgeräten, die kontaktbehaftet ausgeführt sind, verwendet, insbesondere in elektrischen bzw. elektronischen Meß-, Steuer- und Regelkreisen. Das gilt insbesondere für sog. Näherungsschalter, d. h. für elektronische Schaltgeräte, die berührungslos arbeiten. Mit solchen Näherungsschaltern wird indiziert, ob sich ein Beeinflussungselement, für das der entsprechende Näherungsschalter sensitiv ist, dem Näherungsschalter hinreichend weit genähert hat. Hat sich nämlich ein Beeinflussungselement, für das der entsprechende Näherungsschalter sensitiv ist, dem Näherungsschalter hinreichend weit genähert, so steuert der einen wesentlichen Bestandteil des Näherungsschalters bildende Anwesenheitsindikator den elektronischen Schalter um; bei einem als Schließer ausgeführten Schaltgerät wird der nichtleitende elektronische Schalter nunmehr leitend, während bei einem als Öffner ausgeführten Schaltgerät der leitende elektronische Schalter nunmehr sperrt. (Mit Schaltgeräten der in Rede stehenden Art kann auch indiziert werden, ob eine physikalische Größe eines Beeinflussungsmediums, für die das Schaltgerät sensitiv ist, einen entsprechenden Wert überschreitet oder unterschreitet.)

Wesentlicher Bestandteil von elektronischen Schaltgeräten der zuvor beschriebenen Art ist also u. a. der von außen beeinflußbare Anwesenheitsindikator.

Als Anwesenheitsindikator kann z. B. ein induktiv oder kapazitiv beeinflußbarer Oszillator vorgesehen sein; es handelt sich dann um induktive oder kapazitive Näherungsschalter. Als Anwesenheitsindikator kann auch ein Fotowiderstand, eine Fotodiode oder ein Fototransistor vorgesehen sein; es handelt sich dann um optoelektronische Näherungsschalter. Als Anwesenheitsindikator kann schließlich auch eine Temperaturmeßschaltung vorgesehen sein; es handelt sich dann um Strömungswächter.

Bei induktiven Näherungsschaltern gilt für den Oszillator, solange ein Metallteil einen vorgegebenen Abstand noch nicht erreicht hat, K x V = 1 mit K = Rückkopplungsfaktor und V = Verstärkungsfaktor des Oszillators, d. h. der Oszillator schwingt. Erreicht das entsprechende Metallteil den vorgeschriebenen Abstand, so führt die zunehmende Bedämpfung des Oszillators zu einer Verringerung des Verstärkungsfaktors V, d. h. die Amplitude der Oszillatorschwingung geht zurück bzw. der Oszillator hört auf zu schwingen. Bei kapazitiven Näherungsschaltern gilt für den Oszillator, solange ein Ansprechkörper die Kapazität zwischen einer Ansprechelektrode und einer Gegenelektrode noch nicht erreicht hat, K x V < 1, d. h. der Oszillator schwingt nicht. Erreicht der Ansprechkörper den vorgegebenen Abstand, so führt die steigende Kapazität zwischen der Ansprechelektrode und der Gegenelektrode zu einer Vergrößerung des Rückkopplungsfaktors K, so daß K x V = 1 wird, d. h. der Oszillator beginnt zu schwingen. Bei beiden Ausführungsformen - induktiver Näherungsschalter und kapazitiver Näherungsschalter - wird abhängig von den unterschiedlichen Zuständen des Oszillators der elektronische Schalter, z. B. ein Transistor, ein Thyristor oder Triac, gesteuert.

Optoelektronische Näherungsschalter weisen einen Lichtsender und einen Lichtempfänger auf und werden auch als Lichtschranken bezeichnet. Dabei unterscheidet man zwischen einem Lichtschrankentyp, bei dem der Lichtsender und der Lichtempfänger auf entgegengesetzten Seiten einer Überwachungsstrecke angeordnet sind, und einem Lichtschrankentyp, bei dem der Lichtsender und der Lichtempfänger am gleichen Ende einer Überwachungsstrecke angeordnet sind, während ein am anderen Ende der Überwachungsstrecke angeordneter Reflektor den vom Lichtsender ausgehenden Lichtstrahl zum Lichtempfänger zurückreflektiert. In beiden Fällen spricht der Anwesenheitsindikator an, wenn der normalerweise vom Lichtsender zum Lichtempfänger gelangende Lichtstrahl durch ein in die Überwachungsstrecke gelangtes Beeinflussungselement unterbrochen wird. Es gibt jedoch auch Lichtschranken des zuletzt beschriebenen Lichtschrankentyps, bei dem der vom Lichtsender kommende Lichtstrahl nur durch ein entsprechendes Beeinflussungselement zum Lichtempfänger zurückreflektiert wird.

Im folgenden wird als Beispiel immer ein induktiver Näherungsschalter behandelt. Gleichwohl gelten alle Ausführungen jedoch immer auch für andere Arten von elektronischen Schaltgeräten der eingangs beschriebenen und zuvor erläuterten Art, insbesondere für kapazitive und optoelektronische Näherungsschalter und für Strömungswächter.

Elektronische Schaltgeräte der in Rede stehenden Art werden - wie elektrische, mechanisch betätigte Schaltgeräte - sowohl als Schließer (im beeinflußten Zustand des Anwesenheitsindikators ist der elektrische Schalter leitend) als auch als Öffner (im beeinflußten Zustand des Anwesenheitsindikators ist der elektronische Schalter nicht-leitend) benötigt. Da es nun aus Lagerhaltungsgründen unerwünscht ist, einerseits als Schließer, andererseits als Öffner ausgebildete elektronische Schaltgeräte einzusetzen, gibt es eine Vielzahl von elektronischen Schaltgeräten der in Rede stehenden Art, die sowohl als Schließer als auch als Öffner eingesetzt werden können. Insbesondere gibt es elektronische Schaltgeräte, die "anschlußprogrammierbar" sind (vgl. die DE-OSen 31 23 828 und 32 14 836). "Anschlußprogrammierbrar" meint dabei, daß durch einen bestimmten Anschluß des Schaltgerätes an die Versorgungsspannung festgelegt wird, ob das Schaltgerät als Schließer oder als Öffner arbeitet.

Im einzelnen sind unterschiedliche Arten von "anschlußprogrammierbaren" elektronischen Schaltgeräten bekannt. Bei einer ersten Ausführungsform sind - statt der eigentlich nur benötigten zwei - drei oder vier Versorgungsanschlüsse vorgesehen. Abhängig davon, ob die Versorgungsspannung an den ersten und den zweiten Versorgungsanschluß oder an den ersten und den dritten Versorgungsanschluß (Fig. 1 und 3 der DE-OS 31 23 828, Fig. 2 der DE-OS 32 14 836) bzw. an den ersten und den zweiten Versorgungsanschluß oder an den dritten und den vierten Versorgungsanschluß (Fig. 4 der DE-OS 31 23 828) angeschlossen wird, arbeitet das Schaltgerät als Schließer oder als Öffner (oder umgekehrt). Bei einer zweiten Ausführungsform, die unter der Bezeichnung "Quadronorm" am Markt erhebliche Beachtung gefunden hat, sind nur die benötigten zwei Versorgungsanschlüsse vorhanden. Abhängig davon, ob die positive Versorgungsspannung an den ersten und die negative Versorgungsspannung an den zweiten Versorgungsanschluß oder die negative Versorgungsspannung an den ersten und die positive Versorgungsspannung an den zweiten Versorgungsanschluß angelegt wird, arbeitet das "Quadronorm"-Schaltgerät als Öffner oder als Schließer (oder umgekehrt).

Einerseits ist bei den zuvor im einzelnen beschriebenen "anschlußprogrammierbaren" Schaltgeräten - als Teil des Schaltverstärkers oder zwischen dem Schaltverstärker und dem elektronischen Schalter - ein Exklusiv-ODER-Gatter erforderlich und weisen kommerzielle integrierte Schaltkreise (IC's), die für elektronische Schaltgeräte der hier in Rede stehenden Art umfangreich verwendet werden, in der Regel kein Exklusiv-ODER-Gatter auf. Andererseits gibt es eine Vielzahl von speziell für elektronische Schaltgeräte der hier in Rede stehenden Art entwickelten integrierten Schaltkreisen, bei denen der Schaltverstärker zwei antivalente Steuerausgänge aufweist (vgl. die integrierten Schaltkreise TCA 205 und TCA 305 von Siemens und den integrierten Schaltkreis TDE 0160 von THOMSON-CSF).

Der Erfindung liegt nun die Aufgabe zugrunde, weitere Ausführungsformen eines "anschlußprogrammierbaren" elektronischen Schaltgerätes anzugeben, also das eingangs beschriebene elektronische Schaltgerät so auszugestalten und weiterzubilden, daß es "anschlußprogrammierbar" ist.

Das erfindungsgemäße Schaltgerät, bei dem die zuvor hergeleitete und aufgezeigte Aufgabe gelöst ist, ist dadurch gekennzeichnet, daß ein weiterer elektronischer Schalter vorgesehen ist, daß die beiden elektronischen Schalter mit unterschiedlichen Stromdurchlaßrichtungen zueinander parallel an die beiden Versorgungsanschlüsse angeschlossen sind, so daß in den beiden elektronischen Schaltern der Strom jeweils nur in einer Richtung fließen kann, und zwar in unterschiedlichen Richtungen in den beiden Schaltern, und daß die beiden elektronischen Schalter antivalent von den beiden antivalenten Steuerausgängen - Schließer-Steuerausgang und Öffner-Steuerausgang - des Schaltverstärkers steuerbar sind.

Einerseits ist eingangs ausgeführt worden, daß als elektronischer Schalter ein Transistor, ein Thyristor oder ein Triac verwendet werden kann. Andererseits gehört zur zuvor beschriebenen Lehre der Erfindung, daß dafür gesorgt sein muß, daß in den beiden elektronischen Schaltern der Strom jeweils nur in einer Richtung fließen kann, und zwar in unterschiedlichen Richtungen in den beiden Schaltern. Die zuletzt genannte erfindungsgemäße Maßnahme läßt sich sowohl mit Transistoren als auch mit Thyristoren als auch mit Triacs verwirklichen, mit Triacs jedenfalls dann, wenn durch zusätzliche Stromrichtungsdioden dafür gesorgt wird, daß der Strom jeweils nur in einer Richtung fließen kann.

Bei dem zuvor beschriebenen erfindungsgemäßen elektronischen Schaltgerät werden als elektronische Schalter vorzugsweise Transistoren verwendet. Dann muß verhindert werden, daß es zu Stromflüssen oder gar Stromdurchbrüchen zwischen den Transistoranschlüssen kommt, zwischen denen normalerweise kein Strom fließt. Dazu kann jeweils zwischen dem Emitter oder dem Kollektor eines Transistors und dem zugeordneten Versorgungsanschluß eine in Durchlaßrichtung geschaltete Schutzdiode vorgesehen sein. Es kann jedoch auch jeweils der Basis und dem Kollektor jedes Transistors eine in Durchlaßrichtung geschaltete Schutzdiode vorgeschaltet sein.

Erfindungsgemäß ist also erkannt worden, daß die bei integrierten Schaltkreisen für elektronische Schaltgeräte der in Rede stehenden Art häufig vorhandenen antivalenten Steuerausgänge - Schließer-Steuerausgang und Öffner-Steuerausgang - des Schaltverstärkers in überraschend einfacher Weise dazu verwendet werden können, ein "anschlußprogrammierbares" Schaltgerät zu realisieren, ohne daß es eines Exklusiv-ODER-Gatters bedarf.

Ausgestaltungen und Weiterbildungen der Lehre der Erfindung ergeben sich aus den dem Patentanspruch 1 nachgeordneten Patentansprüchen. Im übrigen wird die Erfindung im folgenden anhand einer lediglich Ausführungsbeispiele darstellenden Zeichnung nochmals - und ergänzend - erläutert; es zeigt
- Fig. 1: ein Schaltbild eines ersten Ausführungsbeispiels eines erfindungsgemäßen elektronischen Schaltgerätes,
- Fig. 2: ein Schaltbild eines zweiten Ausführungsbeispiels eines erfindungsgemäßen elektronischen Schaltgerätes und
- Fig. 3: ein Schaltbild eines dritten Ausführungsbeispiels eines erfindungsgemäßen elektronischen Schaltgerätes.

In den Figuren sind jeweils nur Schaltungsdetails von erfindungsgemäßen elektronischen Schaltgeräten, in den Ausführungsbeispielen von induktiven Näherungsschaltern, dargestellt, die für das Verständnis der erfindungsgemäßen Lehre erforderlich sind.

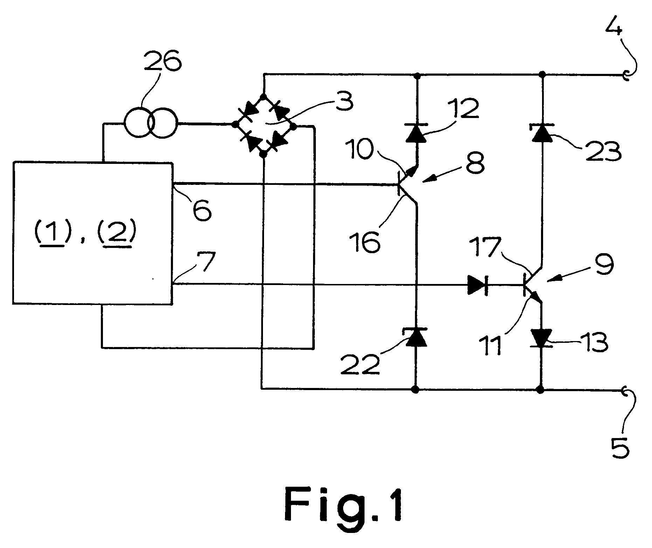

Zu den in den Fig. 1 bis 3 dargestellten elektronischen Schaltgeräten gehören ein von außen beeinflußbarer Anwesenheitsindikator, bei induktiven Näherungsschaltern also ein Oszillator 1, ein dem Anwesenheitsindikator bzw. dem Oszillator 1 nachgeordneter Schaltverstärker 2, ein von dem Anwesenheitsindikator bzw. dem Oszillator 1 über den Schaltverstärker 2 steuerbarer elektronischer Schalter, eine vier Gleichrichterelemente aufweisende Gleichrichterbrücke 3 und zwei Versorgungsanschlüsse 4, 5. Dabei weist jeweils der Schaltverstärker 2 zwei antivalente Steuerausgänge auf, nämlich einen Schließer-Steuerausgang 6 und einen Öffner-Steuerausgang 7.

Wie den Fig. 1 bis 3 entnommen werden kann, ist bei den hier dargestellten Schaltgeräten ein weiterer elektronischer Schalter vorgesehen, sind die beiden elektronischen Schalter antivalent von den beiden antivalenten Steuerausgängen des Schaltverstärkers 2 nämlich dem Schließer-Steuerausgang 6 und dem Öffner-Steuerausgang 7, steuerbar und ist dafür gesorgt, daß in den beiden elektronischen Schaltern der Strom jeweils nur in einer Richtung fließen kann, und zwar in unterschiedlichen Richtungen in den beiden Schaltern. Die beiden elektronischen Schalter sind mit unterschiedlichen Stromdurchlaßrichtungen zueinander parallel an die beiden Versorgungsanschlüsse 4, 5 angeschlossen.

Bei allen in den Fig. 1 bis 3 dargestellten Ausführungsbeispielen sind als elektronische Schalter Transistoren 8, 9 verwendet. Dabei ist die Funktionsfähigkeit der mit den Transistoren 8, 9 als elektronische Schalter versehenen erfindungsgemäßen elektronischen Schaltgeräte in den dargestellten Ausführungsbeispielen unterschiedlich sichergestellt.

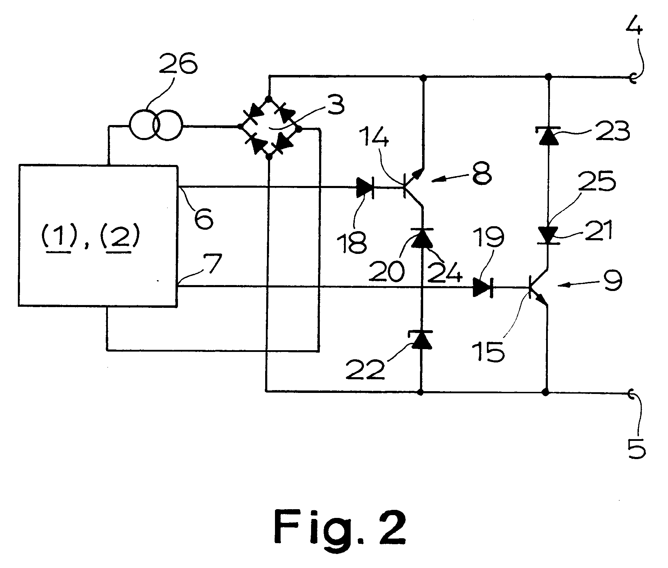

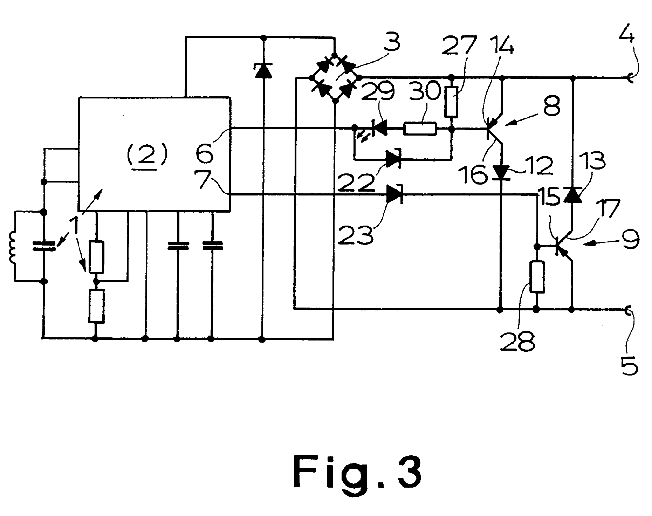

Bei dem in Fig. 1 dargestellten Ausführungsbeispiel ist jeweils zwischen dem Emitter 10, 11 des Transistors 8, 9 und dem zugeordneten Versorgungsanschluß 4, 5 eine in Durchlaßrichtung geschaltete Schutzdiode 12, 13 vorgesehen. Im Ausführungsbeispiel nach Fig. 2 sind jeweils der Basis 14, 15 und dem Kollektor 16, 17 jedes Transistors 8, 9 eine in Durchlaßrichtung geschaltete Schutzdiode 18, 19 bzw. 20, 21 vorgeschaltet. Bei dem in Fig. 3 dargestellten Ausführungsbeispiel ist jeweils zwischen dem Kollektor 16, 17 des Transistors 8, 9 und dem zugeordneten Versorgungsanschluß 4, 5 eine in Durchlaßrichtung geschaltete Schutzdiode 12, 13 vorgesehen.

Bei allen in den Fig. 1 bis 3 dargestellten Ausführungsbeispielen erfindungsgemäßer elektronischer Schaltgeräte handelt es sich um sog. Zweileiter-Schaltgeräte. Einerseits dienen also die Versorgungsanschlüsse 4, 5 der Versorgung der elektronischen Schaltgeräte, d. h. des Oszillators 1 und des Schaltverstärkers 2, mit der für die Funktionsfähigkeit erforderlichen elektrischen Energie. Andererseits sind die Versorgungsanschlüsse 4, 5 zugleich die Schaltausgänge der elektronischen Schaltgeräte; im leitenden Zustand eines der beiden elektronischen Schalter, also des Transistors 8 oder des Transistors 9, fließt also der Laststrom eines nicht dargestellten elektrischen Verbrauchers über die Versorgungsanschlüsse 4, 5. Folglich sind Maßnahmen realisiert, die im leitenden Zustand des Transistors 8 bzw. des Transistors 9 sicherstellen, daß für den Anwesenheitsindikator, also für den Oszillator 1, und für den Schaltverstärker 2 die notwendige elektrische Energie, Speisespannung und Speisestrom, zur Verfügung steht.

Im Ausführungsbeispiel nach Fig. 1 ist zwischen dem jeweiligen Versorgungsanschluß 5, 4 und dem Kollektor 16, 17 des Transistors 8, 9 eine die Speisespannung bzw. den Speisestrom für den Anwesenheitsindikator, also für den Oszillator 1, und den Schaltverstärker 1 sicherstellende Zenerdiode 22, 23 vorgesehen. Bei dem Ausführungsbeispiel nach Fig. 2 sind die Zenerdioden 22, 23 zwischen dem jeweiligen Versorgungsanschluß 5, 4 und der Anode 24, 25 der Schutzdiode 20, 21 vorgesehen. Im Ausführungsbeispiel nach Fig. 3 sind die Zenerdioden 22, 23 zwischen der Basis 14, 15 jedes Transistors und dem zugeordneten Steuerausgang des Schaltverstärkers, also dem Schließer-Steuerausgang 6 und dem Öffner-Steuerausgang 7, vorgesehen.

Im übrigen ist bei allen in den Fig. 1 bis 3 dargestellten Ausführungsbeispielen die Gleichrichterbrücke eingangsseitig an die Versorgungsanschlüsse 4, 5 und ausgangsseitig - in den Ausführungsbeispielen nach den Fig. 1 und 2 über einen Strom- und/oder Spannungsregler 26 - an den Anwesenheitsindikator, also den Oszillator 1, und den Schaltverstärker 2 angeschlossen.

Fig. 3 zeigt, daß bei dem dort dargestellten Ausführungsbeispiel zwischen dem Versorgungsanschluß 4 und der Basis 14 des Transistors 8 sowie zwischen dem Versorgungsanschluß 5 und der Basis 15 des Transistors 9 jeweils ein Pullup-Widerstand 27, 28 vorgesehen ist und daß zwischen der Basis 14 des Transistors 8 und dem Steuerausgang 6 des Schaltverstärkers 2 eine Leuchtdiode 29 mit einem in Reihe geschalteten Schutzwiderstand 30 vorgesehen ist.

## Patentansprüche

1. Elektronisches Schaltgerät zum Anschluß an Gleichspannung als Versorgungsspannung, insbesondere induktiver, kapazitiver oder optoelektronischer Näherungsschalter oder Strömungswächter, mit einem von außen beeinflußbaren Anwesenheitsindikator, z. B. einem Oszillator, mit einem dem Anwesenheitsindikator nachgeordneten Schaltverstärker, mit einem von dem Anwesenheitsindikator über den Schaltverstärker steuerbaren elektronischen Schalter, z. B. einem Transistor, einem Thyristor oder einem Triac, mit einer vier Gleichrichterelemente aufweisenden Gleichrichterbrücke und mit zwei Versorgungsanschlüssen, wobei der Schaltverstärker zwei antivalente Steuerausgänge aufweist, **dadurch gekennzeichnet**, daß ein weiterer elektronischer Schalter vorgesehen ist, daß die beiden elektronischen Schalter mit unterschiedlichen Stromdurchlaßrichtungen zueinander parallel an die beiden Versorgungsanschlüsse (4, 5) angeschlossen sind, so daß in den beiden elektronischen Schaltern der Strom jeweils nur in einer Richtung fließen kann, und zwar in unterschiedlichen Richtungen in den beiden Schaltern, und daß die beiden elektronischen Schalter antivalent von den beiden antivalenten Steuerausgängen - Schließer-Steuerausgang (6) und Öffner-Steuerausgang (7) - des Schaltverstärkers (2) steuerbar sind.

2. Elektronisches Schaltgerät nach Anspruch 1, dadurch gekennzeichnet, daß als elektronische Schalter Transistoren (8, 9) verwendet sind und jeweils zwischen dem Emitter (10, 11) oder dem Kollektor (16, 17) des Transistors (8, 9) und dem zugeordneten Versorgungsanschluß (4, 5) eine in Durchlaßrichtung geschaltete Schutzdiode (12, 13) vorgesehen ist.

3. Elektronisches Schaltgerät nach Anspruch 1, dadurch gekennzeichnet, daß als elektronische Schalter Transistoren (8, 9) verwendet sind und jeweils der Basis (14, 15) und dem Kollektor (16, 17) jedes Transtistors (8, 9) eine in Durchlaßrichtung geschaltete Schutzdiode (18, 19, 20, 21) vorgeschaltet ist.

4. Elektronisches Schaltgerät nach Anspruch 2 oder 2, dadurch gekennzeichnet, daß zwischen dem jeweiligen Versorgungsanschluß (4, 5) und dem Kollektor (16, 17) des Transistors (8, 9) oder der Anode (24, 25) der Schutzdiode (20, 21) oder jeweils zwischen der Kathode der Schutzdiode und dem Kollektor des Transistors eine die Speisespannung bzw. den Speisestrom für den Anwesenheitsindikator und den Schaltverstärker (2) sicherstellende Zenerdiode (22, 23) vorgesehen ist.

5. Elektronisches Schaltgerät nach Anspruch 2, dadurch gekennzeichnet, daß zwischen der Basis (14, 15) jedes Transistors (8, 9) und dem zugeordneten Steuerausgang des Schaltverstärkers eine die Speisespannung bzw. den Speisestrom für den Anwesenheitsindikator und den Schaltverstärker (2) sicherstellende Zenerdiode (22, 23) vorgesehen ist.

6. Elektronisches Schaltgerät nach einem der Ansprüche 1 bis 5, dadurch gekennzeichnet, daß die Gleichrichterbrücke (3) eingangsseitig an die Versorgungsanschlüsse (4, 5) und ausgangsseitig - ggf. über einen Strom- und/oder Spannungsregler (26) - an den Anwesenheitsindikator und den Schaltverstärker (2) angeschlossen ist.

## Claims

1. An electronic switching device for connection to a DC voltage as the supply voltage, particularly an inductive, capacitive or opto-electronic proximity switch or contactor, having an externally influenceable presence indicator, e.g. an oscillator, having a switching amplifier connected downstream of the presence indicator, having an electronic switch, e.g. a transistor, a thyristor or a triac, which can be controlled by the presence indictor via the switching amplifier, having a rectifier bridge comprising four rectifier elements, and having two supply connections, wherein the switching amplifier has two non-equivalent control outputs, characterised in that a further electronic switch is provided, that the two electronic switches are connected in parallel to the two supply connections (4, 5) with different directions of current transmission to each other, so that the current can only flow in one direction in each case in the two electronic switches and flows in different directions in the two switches, and that the two electronic switches can be controlled in a non-equivalent manner by the two non-equivalent control outputs - the normally open control output (6) and the normally closed control output (7) - of the switching amplifier (2).

2. An electronic switching device according to claim 1, characterised in that transistors (8, 9) are used as the electronic switches and a protective diode (12, 13) connected in the direction of current transmission is provided in each case between the emitter (10, 11) or the collector (16, 17) of the transistor (8, 9) and the associated supply connection (4, 5).

3. An electronic switching device according to claim 1, characterised in that transistors (8, 9) are used as the electronic switches and a protective diode (18, 19, 20, 21) connected in the direction of current transmission is in each case connected upstream of the base (14, 15) and of the collector (16, 17) of each transistor (8, 9).

4. An electronic switching device according to claim 2 or 3, characterised in that a Zener diode (22, 23) which ensures the supply voltage or the supply current for the presence indicator and the switching amplifier (2) is provided between the respective supply connection (4, 5) and the collector (16, 17) of the transistor (8, 9) or the anode (24, 25) of the protective diode (20, 21) or between the cathode of the protective diode and the collector of the transistor in each case.

5. An electronic switching device according to claim 2, characterised in that a Zener diode (22, 23) which ensures the supply voltage or the supply current for the presence indicator and the switching amplifier (2) is provided between the base (14, 15) of each transistor (8, 9) and the associated control output of the switching amplifier.

6. An electronic switching unit according to any one of claims 1 to 5, characterised in that the rectifier bridge (3) is connected on its input side to the supply connections (4, 5) and is connected on its output side - optionally via a current and/or voltage regulator (26) - to the presence indicator and the switching amplifier (2).

## Revendications

1. Appareil de commutation électronique pour le raccordement à une tension en courant continu comme tension d'alimentation, en particulier un détecteur de proximité ou un contrôleur du flux, inductif, capacitif ou optoélectronique, comprenant un indicateur de présence qui peut être influencé de l'extérieur, par exemple un oscillateur, un amplificateur de commutation monté en aval de l'indicateur de présence, un contacteur électronique qui peut être commandé par l'indicateur de présence par l'intermédiaire de l'amplificateur de commutation, par exemple un transistor, un thyristor ou un connecteur triax, un pont redresseur présentant quatre éléments de redressement, et deux raccords d'alimentation, dans lequel l'amplificateur de commutation présente deux sorties de commande anticoïncidentes, caractérisé en ce qu'on prévoit un contacteur électronique supplémentaire, en ce que les deux contacteurs électroniques à sens de conduction de courant différents sont raccordés parallèlement l'un à l'autre aux deux raccords d'alimentation (4, 5), si bien que, dans les deux contacteurs électroniques, le courant ne peut circuler respectivement que dans un seul sens et en fait, dans des sens differents dans les deux contacteurs, et en ce que les deux contacteurs électroniques peuvent être commandés de manière anticoïncidente par les deux sorties de commande anticoïncidentes - sortie de commande (6) du contact de travail et sortie de commande (7) du contact de repos - de l'amplificateur de commutation (2).

2. Appareil de commutation électronique selon la revendication 1, caractérisé en ce que, comme contacteur électronique, on utilise des transistors (8, 9) et, respectivement, entre l'émetteur (10, 11) ou le collecteur (16, 17) du transistor (8, 9) et le raccord d'alimentation correspondant (4, 5), on prévoit une diode de protection (12, 13) montée dans le sens de conduction.

3. Appareil de commutation électronique selon la revendication 1, caractérisé en ce que, comme contacteurs électroniques, on utilise des transistors (8, 9) et on intercale en amont respectivement de la base (14, 15) et du collecteur (16, 17) de chaque transistor (8, 9), une diode de protection (18, 19, 20, 21) montée dans le sens de conduction.

4. Appareil de commutation électronique selon la revendication 2 ou 3, caractérisé en ce que, entre le raccord d'alimentation respectif (4, 5) et le collecteur (16, 17) du transistor (8, 9) ou l'anode (24, 25) de la diode de protection (20, 21) ou respectivement entre la cathode de la diode de protection et le collecteur du transistor, on prévoit une diode Zéner (22, 23) garantissant la tension d'alimentation, respectivement le courant d'alimentation pour l'indicateur de présence et pour l'amplificateur de commutation (2).

5. Appareil de commutation électronique selon la revendication 2, caractérisé en ce que, entre la base (14, 15) de chaque transistor (8, 9) et la sortie de commande de l'amplificateur de commutation qui leur est attribuée, on prévoit une diode Zéner (22, 23) garantissant la tension d'alimentation, respectivement le courant d'alimentation pour l'indicateur de présence et pour l'amplificateur de commutation (2).

6. Appareil de commutation électronique selon l'une quelconque des revendications 1 à 5, caractérisé en ce que le pont redresseur (3) est raccordé côté entrée aux raccords d'alimentation (4, 5) et côté sortie - éventuellement à l'intervention d'un régulateur de courant et/ou de tension (26) - à l'indicateur de présence et à l'amplificateur de commutation (2).
